# FASCICULE DE BREVET EUROPEEN

(11) **EP 4 426 093 B1**
(45) Date de publication et mention de la délivrance du brevet: **25.06.2025**
(21) Numéro de dépôt: 24160728.2
(22) Date de dépôt: 29.02.2024
(51) Int. Cl.: H10N 70/20

(54) **COMMUTATEUR A BASE DE MATERIAU A CHANGEMENT DE PHASE**
SCHALTER AUF BASIS VON PHASENWECHSELMATERIAL
PHASE CHANGE MATERIAL BASED SWITCH

(30) Priorité: 03.03.2023 FR 2302012
(43) Date de publication de la demande: 04.09.2024
(73) Titulaire: Commissariat à l'Energie Atomique et aux Energies Alternatives, 75015 Paris (FR)
(72) Inventeur: MERCIER, Denis, 38054 GRENOBLE CEDEX 09 (FR); REIG, Bruno, 38054 GRENOBLE CEDEX 09 (FR)
(74) Mandataire: Cabinet Beaumont

(56) Documents cités:
- US-A1- 2010 012 916
- US-A1- 2016 035 973
- US-A1- 2016 056 373
- US-A1- 2020 058 862

## Description

### Domaine technique

La présente description concerne de façon générale les dispositifs électroniques. La présente description concerne plus particulièrement les commutateurs à base d'un matériau à changement de phase, capable d'alterner entre une phase cristalline, électriquement conductrice, et une phase amorphe, électriquement isolante.

### Technique antérieure

Diverses applications tirent profit de commutateurs, ou interrupteurs, à base d'un matériau à changement de phase pour permettre ou empêcher une circulation d'un courant électrique dans un circuit. De tels commutateurs peuvent notamment être mis en œuvre dans des applications de communication radiofréquence, par exemple pour commuter une antenne entre des modes d'émission et de réception, activer un filtre correspondant à une bande de fréquences, etc.

Les commutateurs à base d'un matériau à changement de phase existants souffrent toutefois de divers inconvénients. Un exemple de l'art antérieur se trouve dans le document US2010012916. Le document divulgue un commutateur à base d'un matériau à changement de phase.

### Résumé de l'invention

Il existe un besoin d'améliorer les commutateurs à base d'un matériau à changement de phase existants.

Pour cela, un mode de réalisation prévoit un commutateur comprenant :
- des première, deuxième et troisième électrodes ;
- une région en un matériau à changement de phase reliant les première, deuxième et troisième électrodes ; et
- des premier, deuxième et troisième éléments chauffants connectés entre une première face de la région en matériau à changement de phase et les première, deuxième et troisième électrodes, respectivement,
les deuxième et troisième éléments chauffants étant destinés à modifier l'état du matériau à changement de phase dans des première et deuxième zones à l'intérieur de ladite région.

Selon un mode de réalisation, le premier élément chauffant est destiné à modifier l'état du matériau à changement de phase dans une troisième zone, différente des première et deuxième zones, à l'intérieur de la région en matériau à changement de phase.

Selon un mode de réalisation, le commutateur comprend en outre une quatrième électrode et un quatrième élément chauffant connecté entre la première face de la région en matériau à changement de phase et la quatrième électrode, le quatrième élément chauffant étant destiné à modifier l'état du matériau à changement de phase dans une quatrième zone, différente des première et deuxième zones, à l'intérieur de ladite région.

Selon un mode de réalisation, les première, deuxième et troisième électrodes sont connectées respectivement à des première, deuxième et troisième régions conductrices correspondant chacune à une électrode de conduction d'un transistor MOS formé dans un substrat.

Selon un mode de réalisation, les première, deuxième et troisième électrodes sont connectées respectivement à des premier, deuxième et troisième circuits de commande comprenant chacun un nœud d'application d'un potentiel de commande.

Selon un mode de réalisation, les première et deuxième zones s'interpénètrent.

Selon un mode de réalisation, les première et deuxième zones sont disjointes.

Selon un mode de réalisation, les première et deuxième électrodes sont destinées à être connectées à un circuit de communication radiofréquence et la troisième électrode est destinée à être portée à un potentiel de référence.

Selon un mode de réalisation, le commutateur comprend en outre au moins un troisième élément chauffant supplémentaire connecté entre la première face de la région en matériau à changement de phase et la troisième électrode, chaque troisième élément chauffant supplémentaire étant destiné à modifier l'état du matériau à changement de phase dans une deuxième zone supplémentaire à l'intérieur de ladite région.

Selon un mode de réalisation, le commutateur comprend en outre au moins un deuxième élément chauffant supplémentaire connecté entre la première face de la région en matériau à changement de phase et la deuxième électrode, chaque deuxième élément chauffant supplémentaire étant destiné à modifier l'état du matériau à changement de phase dans une première zone supplémentaire à l'intérieur de ladite région.

Selon un mode de réalisation, une deuxième face de la région en matériau à changement de phase, opposée à la première face, est revêtue d'une couche conductrice.

Selon un mode de réalisation, la région en matériau à changement de phase est en un matériau chalcogénure.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B et la figure 1C sont des vues schématiques et partielles, respectivement de dessus et en coupe selon les plans BB et CC de la figure 1A, d'un exemple d'un commutateur à base d'un matériau à changement de phase selon un mode de réalisation ;
la figure 2A, la figure 2B et la figure 2C sont des vues de dessus, schématiques et partielles, illustrant différents états du commutateur des figures 1A à 1C ;
la figure 3A, la figure 3B et la figure 3C illustrent, de façon schématique et partielle, des différences de fonctionnement entre un exemple de mémoire à changement de phase et le commutateur des figures 1A à 1C ;
la figure 4A et la figure 4C sont des vues schématiques et partielles, respectivement de dessus et en coupe selon le plan CC de la figure 4A, d'un exemple d'un commutateur à base d'un matériau à changement de phase selon un mode de réalisation ;
la figure 5A et la figure 5B sont des vues schématiques et partielles, respectivement de dessus et en coupe selon le plan BB de la figure 5A, d'un exemple d'un commutateur à base d'un matériau à changement de phase selon un mode de réalisation ;
la figure 6 est une vue de dessus, schématique et partielle, d'un exemple d'un commutateur à base d'un matériau à changement de phase selon un mode de réalisation ;
la figure 7 est une vue de dessus, schématique et partielle, d'un exemple d'un commutateur à base d'un matériau à changement de phase selon un mode de réalisation ; et
la figure 8 est une vue de dessus, schématique et partielle, d'un exemple d'un commutateur à base d'un matériau à changement de phase selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits de commande des commutateurs à base d'un matériau à changement de phase et les applications dans lesquelles peuvent être prévus de tels commutateurs n'ont pas été détaillés, les modes de réalisation et variantes décrits étant compatibles avec les circuits de commande des commutateurs à base d'un matériau à changement de phase usuels et avec les applications usuelles mettant en œuvre des commutateurs à base d'un matériau à changement de phase.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

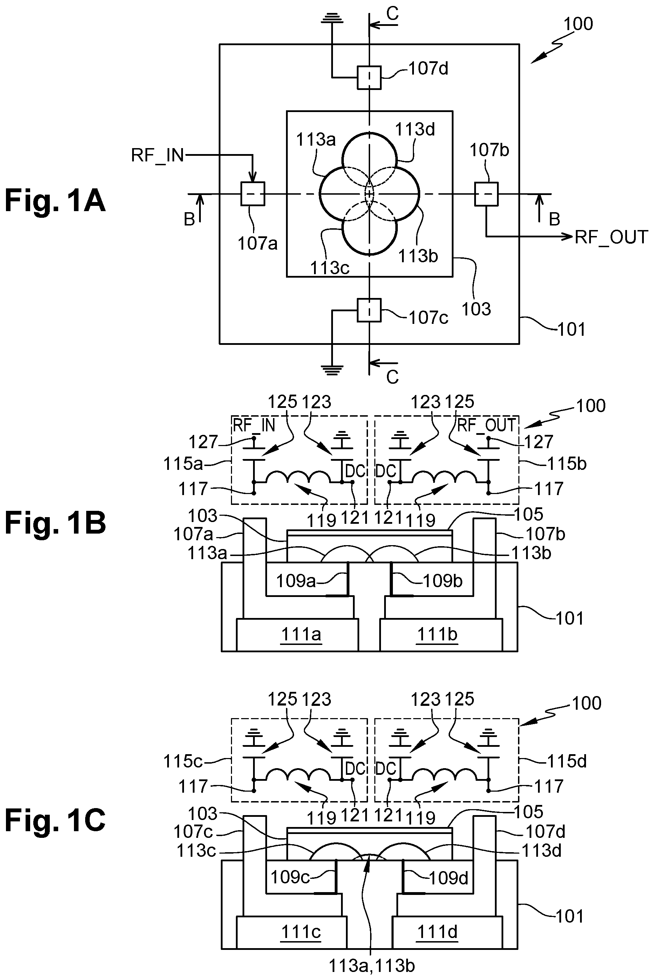

La figure 1A est une vue de dessus, schématique et partielle, d'un exemple d'un commutateur 100 à base d'un matériau à changement de phase selon un mode de réalisation. La figure 1B et la figure 1C sont des vues en coupe du commutateur 100 selon les plans BB et CC, respectivement, de la figure 1A.

Dans l'exemple représenté, le commutateur 100 comprend un substrat 101. Le substrat 101 est par exemple une plaquette ou un morceau de plaquette en un matériau semiconducteur, par exemple le silicium. À titre d'exemple, le substrat 101 est de type CMOS (de l'anglais « Complementary Metal-Oxide-Semiconductor » - métal-oxyde-semiconducteur complémentaire) et comprend une pluralité de transistors MOS (de l'anglais « Metal-Oxide-Semiconductor » - métal-oxyde-semiconducteur) non détaillés en figures 1A à 1C afin de ne pas surcharger le dessin.

Dans l'exemple illustré, une région 103 en un matériau à changement de phase s'étend latéralement sur et en contact avec une face du substrat 101 (la face supérieure du substrat 101, dans l'orientation des figures 1B et 1C). La région 103 présente par exemple, en vue de dessus, un pourtour de forme rectangulaire ou, comme dans l'exemple représenté, sensiblement carrée. Cet exemple n'est toutefois pas limitatif, la région 103 pouvant, à titre de variante, présenter une forme quelconque.

À titre d'exemple, la région 103 du commutateur 100 est en un matériau dit « chalcogénure », c'est-à-dire un matériau ou un alliage comprenant au moins un élément chalcogène, par exemple un matériau de la famille du tellurure de germanium (GeTe), du tellurure d'antimoine (SbTe), du germanium-antimoine-tellure (GeSbTe), plus communément désigné par l'acronyme « GST », ou du tellurure de germanium dopé à l'azote (GeTeN) . La région 103 est par exemple en GeTe, en SbTe, en GeSbTe ou en GeTeN. La région 103 est par exemple constituée d'une couche continue en matériau à changement de phase.

Dans l'exemple représenté, la face de la région 103 en matériau à changement de phase opposée au substrat 101 (la face supérieure de la région 103, dans l'orientation des figures 1B et 1C) est revêtue d'une couche électriquement conductrice 105. La couche conductrice 105 est par exemple déposée sur la face supérieure de la région 103 en matériau à changement de phase. Dans l'exemple représenté, la couche conductrice 105 est continue et revêt intégralement la face de la région 103 opposée au substrat 101. La couche conductrice 105 constitue par exemple une électrode supérieure du commutateur 100 et est par exemple destinée à être portée à un potentiel de référence, par exemple la masse. La couche 105 est par exemple à base d'un métal ou d'un alliage métallique. À titre d'exemple, la couche 105 est en nitrure de titane (TiN). La couche 105 présente par exemple une épaisseur comprise entre 25 et 100 nm, par exemple de l'ordre de 50 nm. La couche 105 n'a pas été représentée en figure 1A afin de ne pas surcharger le dessin. À titre de variante, la couche 105 peut être omise.

Dans l'exemple illustré, le commutateur 100 comprend en outre des électrodes 107, plus précisément quatre électrodes 107a, 107b, 107c et 107d, dans cet exemple. Les électrodes 107 du commutateur 100 sont isolées entre elles. Dans l'exemple représenté, chaque électrode 107 présente, en vue de côté, une forme en L dont une partie horizontale s'étend latéralement dans le substrat 101 à l'aplomb de la couche 103, la partie horizontale de chaque électrode 107 étant séparée de la couche 103 par une distance non nulle, et dont une partie verticale s'étend verticalement dans l'épaisseur du substrat 101 depuis une zone de la face supérieure du substrat 101 non revêtue de la région 103. La partie verticale de chaque électrode 107 peut, comme dans l'exemple illustré, former saillie depuis la face supérieure du substrat 101. Cet exemple n'est toutefois pas limitatif, les électrodes 107 pouvant, à titre de variante, affleurer la face supérieure du substrat 101.

Les électrodes 107 du commutateur 100 sont par exemple en un matériau conducteur, par exemple un métal ou un alliage métallique. À titre d'exemple, les électrodes 107 sont en cuivre. Afin de simplifier la réalisation du commutateur 100, les électrodes 107 présentent par exemple des structures et des compositions sensiblement identiques, aux dispersions de fabrication près.

Les électrodes 107a et 107b sont par exemple destinées à être connectées à un circuit de communication radiofréquence et les électrodes 107c et 107d sont par exemple destinées à être portées à un potentiel de référence, par exemple la masse. À titre d'exemple, les électrodes 107c et 107d peuvent être interconnectées. Dans l'exemple représenté, l'électrode 107a est une électrode d'entrée du commutateur 100 sur laquelle est appliqué un signal radiofréquence RF_IN, l'électrode 107b est une électrode de sortie du commutateur 100 transmettant un signal radiofréquence RF_OUT, et les électrodes 107c et 107d sont connectées à la masse.

Dans l'exemple représenté, le commutateur 100 comprend en outre des éléments chauffants 109 (« heater », en anglais), plus précisément quatre éléments chauffants 109a, 109b, 109c et 109d, dans cet exemple. Les éléments chauffants 109 du commutateur 100 sont isolés entre eux. Les éléments chauffants 109a, 109b, 109c et 109d sont connectés entre la face de la région 103 revêtant le substrat 101 (la face inférieure de la région 103, dans l'orientation des figures 1B et 1C) et les électrodes 107a, 107b, 107c et 107d, respectivement. Dans l'exemple illustré, chaque élément chauffant 109a, 109b, 109c, 109d présente une forme en L dont une partie horizontale s'étend latéralement sur et en contact avec la partie horizontale du L formé par l'électrode 107a, 107b, 107c, 107d correspondante, et dont une partie verticale, située à l'aplomb de la région 103 en matériau à changement de phase, s'étend verticalement dans l'épaisseur du substrat 101 depuis la face supérieure du substrat 101 jusqu'à l'électrode 107a, 107b, 107c, 107d correspondante. Dans l'orientation des figures 1B et 1C, l'extrémité supérieure de la partie verticale de chaque élément chauffant 109 affleure une zone de la face supérieure du substrat 101 revêtue de la région 103 et est en contact mécanique avec la face inférieure de la région 103. Les éléments chauffants 109 contactent la région 103 en des endroits différents, par exemple espacés les uns des autres de quelques dizaines de nanomètres. Les figures 1A à 1C illustrent un exemple dans lequel le commutateur 100 comprend une seule couche conductrice continue 105. Toutefois, cet exemple n'est pas limitatif et le commutateur 100 peut, à titre de variante, comporter plusieurs couches conductrices disjointes, par exemple quatre couches conductrices disjointes situées respectivement à l'aplomb de zones de contact des éléments chauffants 109 avec la face inférieure de la région 103.

Dans l'exemple illustré, le commutateur 100 comprend en outre des régions conductrices 111, plus précisément quatre régions 111a, 111b, 111c et 111d, dans l'exemple représenté. Les régions conductrices 111 du commutateur 100 sont par exemple isolées entre elles, et correspondent par exemple à des électrodes de conduction (source ou drain) de transistors MOS formés dans le substrat 101. Dans l'orientation des figures 1B et 1C, chaque région conductrice 111a, 111b, 111c, 111d est en contact mécanique, par sa face supérieure, avec la face inférieure de la partie horizontale du L formé par l'électrode 107a, 107b, 107c, 107d, respectivement.

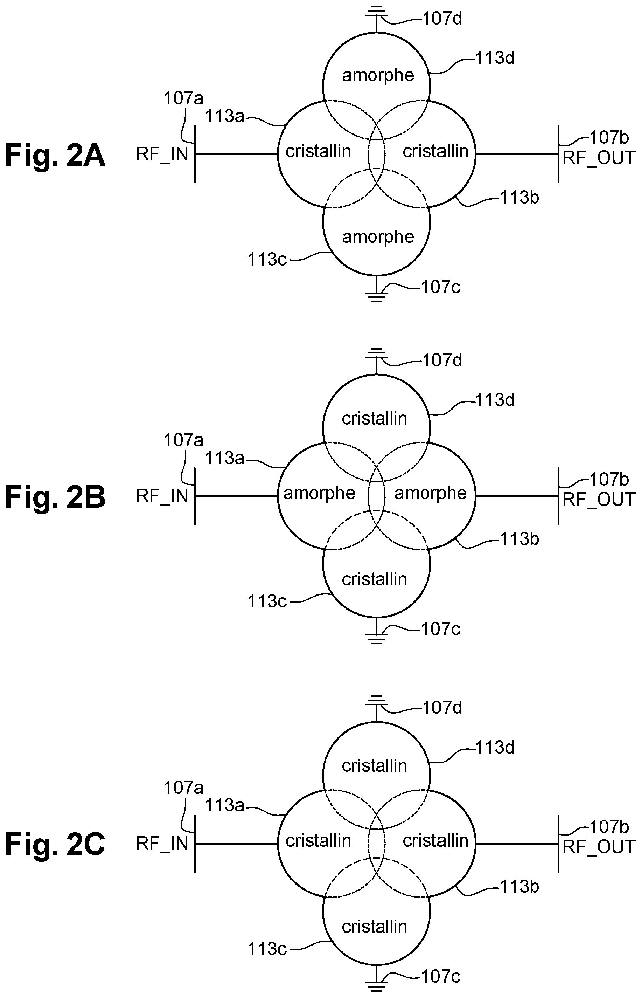

La figure 2A, la figure 2B et la figure 2C sont des vues de dessus, schématiques et partielles, illustrant différents états du commutateur des figures 1A à 1C.

Les matériaux à changement de phase sont, de manière générale, des matériaux capables d'alterner, sous l'effet d'une variation de température, entre une phase cristalline et une phase amorphe, la phase amorphe présentant une résistance électrique supérieure à celle de la phase cristalline. Dans le cas du commutateur 100, il est tiré profit de ce phénomène pour obtenir :
- un premier état (figure 2A), appelé « état passant », permettant la transmission d'un signal radiofréquence entre les électrodes 107a et 107b, lorsque le matériau de deux zones 113a et 113b de la région 103, situées respectivement à l'aplomb des parties verticales des éléments chauffants 109a et 109b, est dans la phase cristalline et lorsqu'une partie au moins du matériau de deux autres zones 113c et 113d de la région 103, situées respectivement à l'aplomb des parties verticales des éléments chauffants 109c et 109d, est dans la phase amorphe ;
- un deuxième état (figure 2B), appelé « état bloqué réfléchissant », empêchant la transmission d'un signal radiofréquence entre les électrodes 107a et 107b, lorsqu'une partie au moins du matériau des zones 113a et 113b de la région 103 est dans la phase amorphe et lorsque le matériau des zones 113c et 113d de la région 103 est dans la phase cristalline ; et
- un troisième état (figure 2C), appelé « état bloqué absorbant », permettant la transmission partielle d'un signal radiofréquence entre les électrodes 107a et 107b, et éventuellement entre l'électrode 107a et les électrodes 107c et 107d, lorsque le matériau des zones 113a, 113b, 113c et 113d de la région 103 est dans la phase cristalline.

Dans l'exemple représenté, chaque zone 113a, 113b, 113c, 113d de la région 103 présente la forme d'une calotte sphérique sensiblement centrée, en vue de dessus, par rapport à l'endroit où la partie verticale de l'élément chauffant 109a, 109b, 109c, 109d, destiné à modifier l'état du matériau à changement de phase dans la zone correspondante, est en contact mécanique avec la face inférieure de la région 103. Dans l'exemple illustré, les zones 113a, 113b, 113c et 113d s'interpénètrent, chaque zone 113a, 113b, 113c, 113d étant en contact avec toutes les autres zones. À titre d'exemple, chaque zone 113a, 113b, 113c, 113d présente, en vue de dessus, une dimension latérale maximale (correspondant, dans cet exemple, au diamètre du cercle de base de la calotte sphérique formée par la zone 113a, 113b, 113c, 113d considérée) de l'ordre de quelques dizaines de nanomètres, par exemple égale à environ 40 nm.

Lors des commutations du commutateur 100 entre les états passant et bloqué réfléchissant, des tensions de commande sont par exemple appliquées simultanément entre les régions 111a, 111b, 111c et 111d, d'un part, et la couche 105, d'autre part, afin de provoquer une circulation de courant à travers les éléments chauffants 109a, 109b, 109c et 109d, respectivement. Ce courant entraîne, par effet Joule puis par rayonnement et/ou conduction à l'intérieur de la structure du commutateur 100, notamment à travers la couche 103, une élévation de température à l'intérieur des zones 113a, 113b, 113c et 113d depuis la face inférieure de la région 103.

Plus précisément, pour faire basculer le commutateur 100 de l'état bloqué réfléchissant à l'état passant, les zones 113a et 113b de la région 103 en matériau à changement de phase sont chauffées, au moyen des éléments chauffants 109a et 109b, par exemple à une température T1 et pendant une durée d1. La température T1 et la durée d1 sont choisies de sorte à provoquer un changement de phase du matériau des zones 113a et 113b depuis la phase amorphe vers la phase cristalline. La température T1 est par exemple supérieure à une température de cristallisation et inférieure à une température de fusion du matériau de la région 103. À titre d'exemple, la température T1 est comprise entre 150 et 350 °C et la durée d1 est inférieure à 1 µs. Dans le cas où la région 103 est en tellurure de germanium, la température T1 est par exemple égale à environ 300 °C et la durée d1 est par exemple comprise entre 100 ns et 1 µs.

Par ailleurs, les zones 113c et 113d de la région 103 en matériau à changement de phase sont chauffées, au moyen des éléments chauffants 109c et 109d, par exemple à une température T2 supérieure à la température T1, et pendant une durée d2 inférieure à la durée d1. La température T2 et la durée d2 sont choisies de sorte à provoquer un changement de phase du matériau des zones 113c et 113d depuis la phase cristalline vers la phase amorphe. La température T2 est par exemple supérieure à la température de fusion du matériau à changement de phase. À titre d'exemple, la température T2 est comprise entre 600 et 1 000 °C et la durée d2 est inférieure à 500 ns. Dans le cas où la région 103 est en tellurure de germanium, la température T2 est par exemple égale à environ 700 °C et la durée d2 est par exemple égale à environ 100 ns.

Lors de la commutation du commutateur 100 entre l'état bloqué réfléchissant et l'état passant, les éléments chauffants 109a, 109b, 109c et 109d sont par exemple commandés de façon simultanée. Cela permet avantageusement de réduire la durée de commutation.

À l'inverse, pour faire basculer le commutateur 100 de l'état passant à l'état bloqué réfléchissant, les zones 113a et 113b sont chauffées, au moyen des éléments chauffants 109a et 109b, par exemple à la température T2 et pendant la durée d2. Par ailleurs, les zones 113c et 113d sont chauffées, au moyen des éléments chauffants 109c et 109d, par exemple à la température T1 et pendant la durée d1.

Ainsi, lors des commutations entre l'état passant et l'état bloqué réfléchissant, les éléments chauffants 109a et 109b, d'une part, et les éléments chauffants 109c et 109d, d'autre part, sont par exemple commandés simultanément et en opposition. À titre d'exemple, les éléments chauffants 109c et 109d sont destinés à être commandés de sorte à faire passer les zones 113c et 113d en matériau à changement de phase d'un premier état à un deuxième état (par exemple de l'état cristallin à l'état amorphe) lorsque les éléments chauffants 109a et 109b sont commandés de sorte à faire passer les zones 113a et 113b en matériau à changement de phase du deuxième au premier état (de l'état amorphe à l'état cristallin, dans cet exemple).

La commutation entre les états bloqué réfléchissant et bloqué absorbant est par exemple analogue à la commutation entre les états passant et bloqué réfléchissant décrite ci-dessus, à la différence que seuls les éléments chauffants 109a et 109b sont mis en œuvre pour la commutation entre les états bloqué réfléchissant et bloqué absorbant, le matériau des zones 113c et 113d restant dans la phase cristalline lors de cette commutation. À titre d'exemple, pour faire basculer le commutateur 100 de l'état bloqué réfléchissant à l'état bloqué absorbant, les zones 113a et 113b de la régions 103 sont chauffées à la température T1 et pendant la durée d1. À l'inverse, pour faire basculer le commutateur 100 de l'état bloqué absorbant à l'état bloqué réfléchissant, les zones 113a et 113b sont par exemple chauffées à la température T2 et pendant la durée d2.

Par ailleurs, la commutation entre les états passant et bloqué absorbant est par exemple analogue à la commutation entre les états passant et bloqué réfléchissant décrite ci-dessus, à la différence que seuls les éléments chauffants 109c et 109d sont mis en œuvre pour la commutation entre l'état passant et l'état bloqué absorbant, le matériau des zones 113a et 113b restant dans la phase cristalline lors de cette commutation. À titre d'exemple, pour faire basculer le commutateur 100 de l'état passant à l'état bloqué absorbant, les zones 113c et 113d de la région 103 sont chauffées à la température T1 et pendant la durée d1. À l'inverse, pour faire basculer le commutateur 100 de l'état bloqué absorbant à l'état passant, les zones 113c et 113d sont par exemple chauffées à la température T2 et pendant la durée d2.

Les valeurs des températures T1 et T2 et des durées d1 et d2 de chauffage peuvent être sensiblement identiques pour chacune des zones 113a, 113b, 113c, 113d.

À titre de variante ou à titre complémentaire, les éléments chauffants 109a, 109b, 109c et 109d du commutateur 100 peuvent être commandés par des circuits de commande 115, plus précisément par quatre circuits de commande 115a, 115b, 115c et 115d, respectivement, dans cet exemple. Chaque circuit 115a, 115b, 115c, 115d comprend :
- un nœud 117 destiné à être connecté à l'électrode 107a, 107b, 107c, 107d correspondante ;
- un élément inductif 119 connecté entre le nœud 117 et un autre nœud 121 d'application d'un potentiel de commande, par exemple un potentiel continu (DC) ;
- un élément capacitif 123 connecté entre le nœud 121 et un autre nœud d'application d'un potentiel de référence, par exemple la masse ; et
- un autre élément capacitif 125 connecté entre le nœud 117 et, dans le cas des circuits 115a et 115b, un autre nœud 127 d'application d'un signal radiofréquence correspondant par exemple au signal RF_IN pour le circuit 115a et au signal RF_OUT pour le circuit 115b ou, dans le cas des circuits 115c et 115d, un autre nœud d'application d'un potentiel de référence, par exemple la masse.

À titre d'exemple, les circuits 115a, 115b, 115c et 115d peuvent être formés dans le substrat 101 ou dans un autre substrat superposé au substrat 101, dans l'orientation des figures 1B et 1C.

Lors des commutations du commutateur 100 entre les états passant, bloqué réfléchissant et bloqué absorbant, les circuits de commande 115a, 115b, 115c et 115d peuvent, conjointement aux régions 111 ou à la place des régions 111, être mis en œuvre pour appliquer aux éléments chauffants 109a, 109b, 109c et 109d la tension adéquate permettant aux zones 113a, 113b, 113c et 113d correspondantes d'alterner entre les phases amorphes et cristallines comme exposé précédemment. Dit autrement, la tension de polarisation de chaque élément chauffant 109 du commutateur 100 peut être appliquée soit au moyen des régions 111 seules, soit au moyen des circuits 115 seuls, soit conjointement au moyen des régions 111 et des circuits 115.

Le commutateur 100 utilise avantageusement le principe de fonctionnement d'une mémoire de type PCRAM (de l'anglais « Phase-Change Random Access Memory » - mémoire à changement de phase à accès aléatoire) mais avec quatre zones mémoire, dans l'exemple représenté, contrairement à une cellule d'une mémoire PCRAM qui n'en utilise qu'une seule. Le commutateur 100 se distingue en outre des commutateurs radiofréquence à base d'un matériau à changement de phase existants en ce qu'il ne nécessite pas de commuter tout le volume de matériau à changement de phase de la région 103. Dans le commutateur 100, les quatre zones mémoire sont obtenues grâce à la présence de cinq bornes, en l'espèce les éléments chauffants 109 et la région conductrice 105, agencées de sorte à modifier la phase du matériau dans les zones 113. La présence de ces quatre zones mémoire permet à la structure de répondre aux exigences d'un commutateur radiofréquence, notamment en termes de rapport R_{off}/Rₒₙ, à la différence des cellules de mémoires PCRAM existantes qui présentent des rapports R_{off}/Rₒₙ inférieurs. À titre d'exemple, le rapport R_{off}/Rₒₙ du commutateur 100 est supérieur à mille, voire supérieur à dix mille, tandis qu'une cellule de mémoire PCRAM présente un ratio R_{off}/Rₒₙ de l'ordre de cent.

Un avantage du commutateur 100 tient au fait que l'état bloqué réfléchissant permet d'obtenir une meilleure isolation, par exemple améliorée d'environ -20 dB, entre les électrodes 107a et 107b par rapport au cas d'un commutateur analogue mais dépourvu par exemple des électrodes 107c et 107d, des éléments chauffants 109c et 109d, et des régions 111c et 111d. Un autre avantage du commutateur 100 réside dans le fait qu'il est possible de tirer profit de l'état bloqué absorbant pour atténuer le signal transmis entre les électrodes de conduction 107a et 107b.

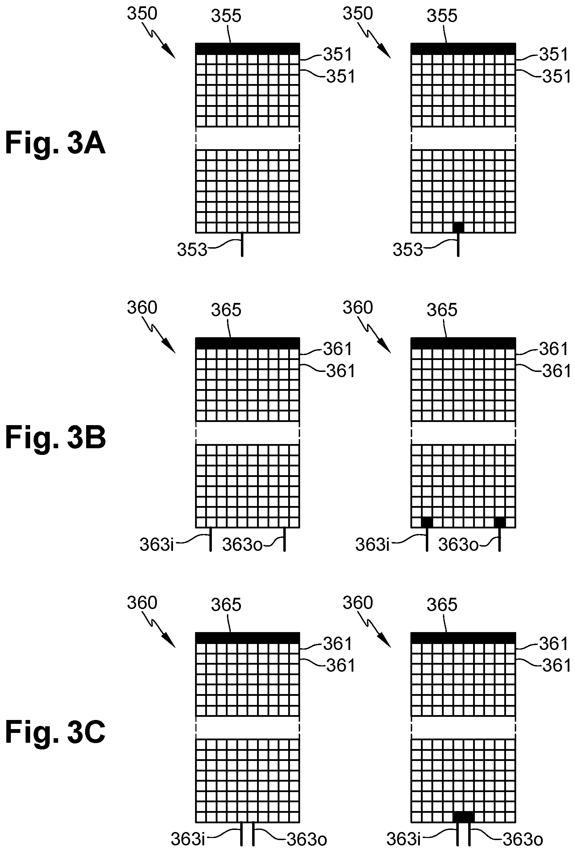

La figure 3A, la figure 3B et la figure 3C illustrent, de façon schématique et partielle, des différences de fonctionnement entre un exemple de mémoire à changement de phase et le commutateur des figures 1A à 1C.

La figure 3A représente schématiquement une zone 350 en matériau à changement de phase décomposée en colonnes comprenant chacune cent mailles élémentaires carrées 351. Dans la partie gauche de la figure 3A, le matériau des mailles élémentaires 351 de chaque colonne est à l'état cristallin. À titre d'exemple, chaque maille élémentaire 351 présente une résistance élémentaire sensiblement égale à 1 Ω, à l'état cristallin, et sensiblement égale à 1 kΩ, à l'état amorphe. À gauche, dans l'exemple illustré, la zone 350 présente une résistance à l'état passant Rₒₙ sensiblement égale à 100 Ω (cent mailles élémentaires de 1 Ω en série). La résistance Rₒₙ correspond par exemple à une résistance à l'état passant entre un doigt d'entrée inférieur 353 et une électrode supérieure 355. Dans la partie droite de la figure 3A, la maille élémentaire 351 en contact avec le doigt 353 commute depuis l'état cristallin vers l'état amorphe. La zone 350 présente alors une résistance à l'état bloqué R_{off} sensiblement égale à 10 099 Ω (99 mailles élémentaires de 1 Ω et une maille élémentaire de 10 kΩ en série). La résistance R_{off} correspond à une résistance à l'état bloqué entre le doigt 353 et l'électrode 355. Dans la configuration illustrée en figure 3A, le rapport R_{off}/Rₒₙ est sensiblement égal à cent (10 099/100). Cette configuration correspond typiquement à une mémoire PCRAM comprenant une électrode inférieure (doigt inférieur 353) et une électrode supérieure 355. Un tel rapport R_{off}/Rₒₙ n'est pas compatible avec une application de commutateur radiofréquence.

La figure 3B représente schématiquement une zone 360 en matériau à changement de phase décomposée en colonnes comprenant chacune cent mailles élémentaires carrées 361. Dans la partie gauche de la figure 3B, le matériau des mailles élémentaires 361 de chaque colonne est à l'état cristallin. À titre d'exemple, chaque maille élémentaire 361 présente une résistance élémentaire sensiblement égale à 1 Ω, à l'état cristallin, et sensiblement égale à 1 kΩ, à l'état amorphe. À gauche, dans l'exemple illustré, la zone 360 présente, entre un doigt d'entrée inférieur 353i et un doigt de sortie inférieur 353o, une résistance à l'état passant Rₒₙ sensiblement égale à 7 Ω (deux demi-carrés de 0,5 Ω et six carrés pleins de 1 Ω en série entre les doigts 353i et 353o). Dans la partie droite de la figure 3B, les mailles élémentaires 361 en contact respectivement avec les doigts 363i et 363o commutent depuis l'état cristallin vers l'état amorphe. La zone 360 présente alors, entre les doigts 363i et 363o, une résistance à l'état bloqué R_{off} sensiblement égale à 10 006 Ω (deux demi-carrés de 5 kΩ et six carrés pleins de 1 Ω en série entre les doigts 353i et 353o). Dans la configuration illustrée en figure 3B, le rapport R_{off}/Rₒₙ est sensiblement égal à 1 429 (10 006/7). Par rapport à la configuration de la figure 3A, la configuration de la figure 3B permet avantageusement d'augmenter le rapport R_{off}/Rₒₙ d'un facteur supérieur à 10. La commutation des zones élémentaires 361 en contact avec les doigts 363i et 363o s'effectue par exemple en appliquant respectivement un premier signal de commande entre le doigt d'entrée 363i et une électrode supérieure 365, et un deuxième signal de commande, différent du premier signal de commande, entre le doigt de sortie 363o et l'électrode 365. Les doigts d'entrée 363i et de sortie 363o sont par exemple analogues ou identiques à deux des éléments chauffants 109 du commutateur 100, par exemple les éléments chauffants 109b et 109d, et l'électrode supérieure 365 est par exemple analogue ou identique à la couche conductrice 105 du commutateur 100.

Le rapport R_{off}/Rₒₙ peut être augmenté davantage en rapprochant les doigts d'entrée 363i et de sortie 363o comme illustré en figure 3C. Dans ce cas, la résistance Rₒₙ est égale à environ 1 Ω (deux demi-carrés de 1 Ω en série entre les doigts 353i et 353o) et la résistance R_{off} est égale à environ 10 kΩ (deux demi-carrés de 5 kΩ en série). Dans ce cas, le rapport R_{off}/Rₒₙ est égal à environ 10 000. Par rapport à la configuration de la figure 3A, la configuration de la figure 3C permet d'augmenter le rapport R_{off}/Rₒₙ d'un facteur de l'ordre de cent.

Le commutateur 100 tire profit d'une structure de type PCRAM comprenant au moins deux électrodes inférieures permettant de créer deux zones mémoire à l'aide d'une troisième électrode supérieure, cette configuration permettant de conserver les avantages d'une mémoire PCRAM en termes de temps de commutation tout en gagnant un facteur dix, cent, ou plus sur le rapport R_{off}/Rₒₙ.

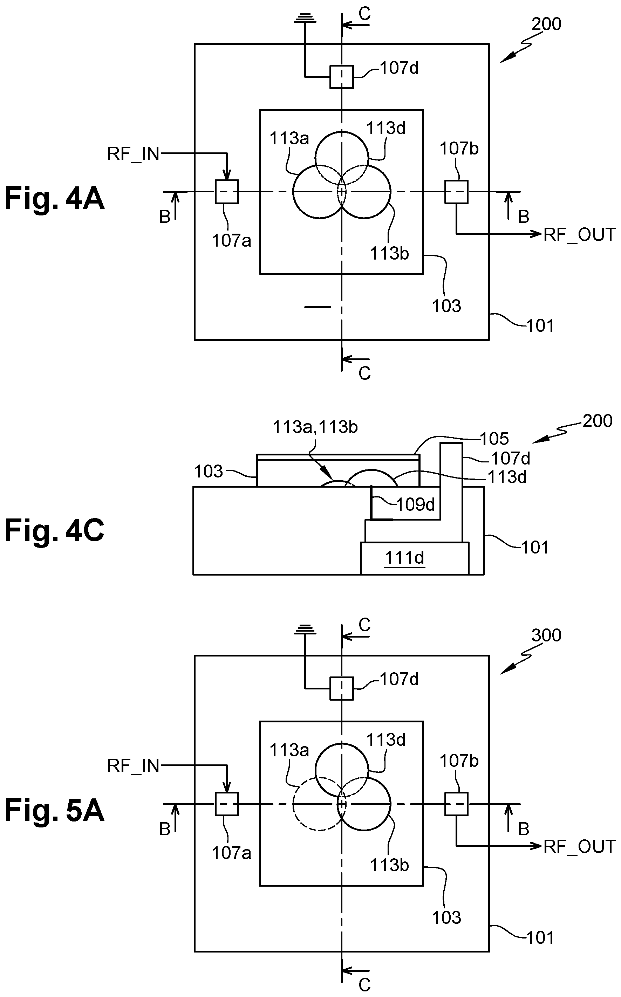

La figure 4A est une vue de dessus, schématique et partielle, d'un exemple d'un commutateur 200 à base d'un matériau à changement de phase selon un mode de réalisation. La figure 4C est une vue en coupe, selon le plan CC de la figure 4A, du commutateur 200. Le commutateur 200 présente, en vue en coupe selon le plan BB de la figure 4A, une structure analogue ou identique à celle du commutateur 100 illustrée en figure 1B.

Le commutateur 200 des figures 4A et 4C comprend des éléments communs avec le commutateur 100 des figures 1A à 1C. Ces éléments communs ne seront pas détaillés à nouveau ci-après. Le commutateur 200 des figures 4A et 4C diffère du commutateur 100 des figures 1A à 1C en ce que le commutateur 200 est dépourvu de l'électrode 107c, de l'élément chauffant 109c et de la région conductrice 111c. Le fonctionnement du commutateur 200 est par exemple analogue à celui du commutateur 100 exposé précédemment en relation avec les figures 1A à 1C. Le fonctionnement du commutateur 200 diffère de celui du commutateur 100 en ce que, dans le commutateur 200, seuls les éléments chauffants 109a, 109b et 109d sont commandés pour permettre d'obtenir les états passant, bloqué réfléchissant et bloqué absorbant.

Bien que cela n'ait pas été illustré en figure 4C, l'électrode 107d du commutateur 200 peut être connectée au circuit de commande 115d précédemment décrit en relation avec la figure 1C.

Un avantage du commutateur 200 tient au fait qu'il présente une structure comprenant moins d'éléments que le commutateur 100. Cela permet de simplifier la réalisation et la commande du commutateur 200 par rapport au commutateur 100.

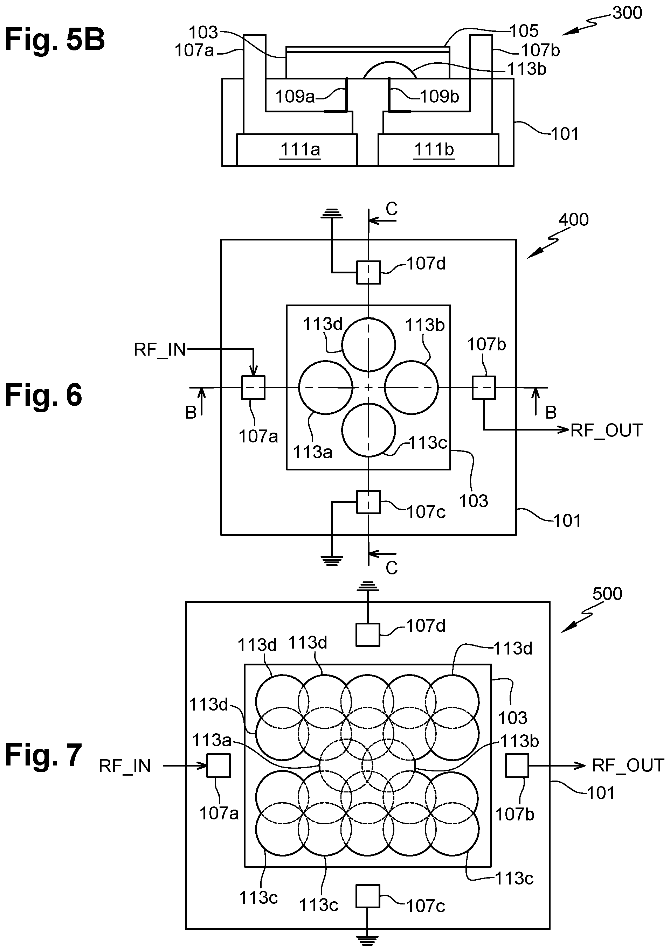

La figure 5A est une vue de dessus, schématique et partielle, d'un exemple d'un commutateur 300 à base d'un matériau à changement de phase selon un mode de réalisation. La figure 5B est une vue en coupe, selon le plan BB de la figure 5A, du commutateur 300. Le commutateur 300 présente, en vue en coupe selon le plan CC de la figure 5A, une structure analogue ou identique à celle du commutateur 200 illustrée en figure 4C.

Le commutateur 300 des figures 5A et 5B comprend des éléments communs avec le commutateur 200 des figures 4A et 4C. Ces éléments communs ne seront pas détaillés à nouveau ci-après. Le commutateur 300 des figures 5A et 5B diffère du commutateur 200 des figures 4A et 4C en ce que l'élément chauffant 109a du commutateur 300 n'est pas destiné à modifier l'état du matériau à changement de phase dans la zone 113a de la région 103, le matériau restant par exemple dans la phase cristalline à l'intérieur de cette zone quel que soit l'état du commutateur 300. À titre d'exemple, le circuit de commande 115a et/ou la région conductrice 111a peuvent être omis.

Le fonctionnement du commutateur 300 est par exemple analogue à celui du commutateur 100 exposé précédemment en relation avec les figures 1A à 1C. Le fonctionnement du commutateur 300 diffère de celui du commutateur 100 en ce que, dans le commutateur 300, l'élément chauffant 109a n'est soumis à aucun potentiel de commande destiné à modifier la phase de la zone 113a. Bien que cela n'ait pas été illustré en figure 5B, l'électrode 107b du commutateur 300 peut être connectée au circuit de commande 115b précédemment décrit en relation avec la figure 1B.

Un avantage du commutateur 300 tient au fait qu'il présente une structure comprenant moins d'éléments que le commutateur 100. Cela permet de simplifier la réalisation et la commande du commutateur 300 par rapport au commutateur 100.

La figure 6 est une vue de dessus, schématique et partielle, d'un exemple d'un commutateur 400 à base d'un matériau à changement de phase selon un mode de réalisation. Le commutateur 400 présente, en vue en coupe selon les plans BB et CC de la figure 6, une structure analogue à celle du commutateur 100 illustrée en figures 1B et 1C, respectivement.

Le commutateur 400 de la figure 6 comprend des éléments communs avec le commutateur 100 des figures 1A à 1C. Ces éléments communs ne seront pas détaillés à nouveau ci-après. Le commutateur 400 de la figure 6 diffère du commutateur 100 des figures 1A à 1C en ce que les zones 113a, 113b, 113c et 113d du commutateur 400 sont disjointes. Dans l'exemple représenté, chaque zone 113a, 113b, 113c, 113d est séparée des autres zones par des parties de la région 103 qui restent dans la phase cristalline quel que soit l'état du commutateur 400, la région 103 étant par exemple dans la phase cristalline à l'issue de la fabrication du commutateur 400. Le commutateur 400 correspond par exemple à un cas dans lequel les éléments chauffants 109 sont plus éloignés les uns des autres que dans le cas du commutateur 100, par exemple en raison de dispersions de fabrication.

Bien que la figure 6 illustre un exemple dans lequel toutes les zones 113a, 113b, 113c et 113d sont disjointes, le commutateur 400 pourrait, à titre de variante, comprendre au moins deux zones jointives, ou s'interpénétrant, parmi les zones 113a, 113b, 113c et 113d.

Le fonctionnement du commutateur 400 est par exemple identique à celui du commutateur 100 exposé précédemment en relation avec les figures 1A à 1C.

La figure 7 est une vue de dessus, schématique et partielle, d'un exemple d'un commutateur 500 à base d'un matériau à changement de phase selon un mode de réalisation.

Le commutateur 500 de la figure 7 comprend des éléments communs avec le commutateur 100 des figures 1A à 1C. Ces éléments communs ne seront pas détaillés à nouveau ci-après. Le commutateur 500 de la figure 7 diffère du commutateur 100 des figures 1A à 1C en ce que le commutateur 500 comprend plusieurs éléments chauffants 109c connectés à l'électrode 107c, et plusieurs éléments chauffants 109d connectés à l'électrode 107d. Les éléments chauffants 109c et 109d n'ont pas été représentés en figure 7 afin de ne pas surcharger le dessin. Les éléments chauffants 109c et 109d du commutateur 500 sont aptes à former, dans la région 103 en matériau à changement de phase, plusieurs zones 113c jointives et plusieurs zones 113d jointives, chaque zone 113c, 113d étant sensiblement centrée sur l'endroit où l'élément chauffant 109c, 109d est en contact mécanique avec la région 103. Les éléments chauffants 109c et 109d sont par exemple connectés à la région 103, d'une part, et à l'électrode 107c ou 107d, d'autre part. Le fonctionnement du commutateur 500 est par exemple identique à celui du commutateur 100 exposé précédemment en relation avec les figures 1A à 1C. La commutation des zones 113c et 113d du commutateur 500 entre les phases cristalline et amorphe est par exemple commandée de façon simultanée.

La figure 7 illustre un exemple dans lequel le commutateur 500 comprend deux rangées de zones 113c et deux rangées de zones 113d, par exemple associées chacune à une rangée d'éléments chauffants 109c ou 109d. Cet exemple n'est toutefois pas limitatif, le commutateur 500 pouvant comprendre un nombre quelconque, supérieur ou égal à un, par exemple compris entre un et cinq, de rangées de zones 113c et de rangées de zones 113d. Les zones 113c et 113d peuvent, à titre de variante, être organisées de manière différente que sous forme de rangées. Par ailleurs, bien que la figure 7 illustre un exemple dans lequel les rangées comprennent des nombres de zones 113c ou 113d identiques, cet exemple n'est pas limitatif, le commutateur 500 pouvant, à titre de variante, présenter un nombre quelconque, supérieur ou égal à un, de zones 113c ou 113d par rangée. Dit autrement, le commutateur 500 peut comprendre un nombre quelconque, supérieur ou égal à un, d'éléments chauffants 109c et un nombre quelconque, supérieur ou égal à un, d'éléments chauffants 109d, ces éléments chauffants pouvant être organisés sous forme d'un nombre quelconque de rangées comprenant chacune un nombre quelconque, supérieur ou égal à un, d'éléments chauffants.

Un avantage du commutateur 500 tient au fait que la mise en parallèle des zones 113c et 113d permet de diminuer une résistance série des connexions à la masse et d'augmenter l'isolation lorsque le commutateur est dans l'état bloqué réfléchissant.

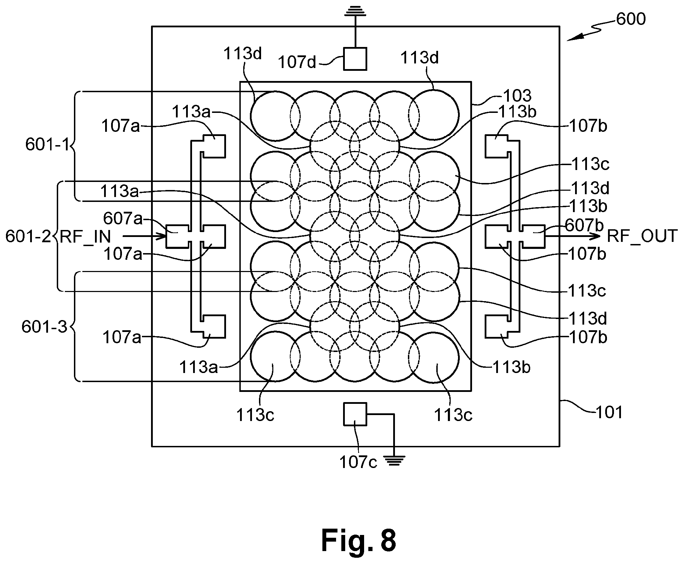

La figure 8 est une vue de dessus, schématique et partielle, d'un exemple d'un commutateur 600 à base d'un matériau à changement de phase selon un mode de réalisation.

Le commutateur 600 de la figure 8 comprend des éléments communs avec le commutateur 500 de la figure 7. Ces éléments communs ne seront pas détaillés à nouveau ci-après. Le commutateur 600 de la figure 8 diffère du commutateur 500 de la figure 7 en ce que le commutateur 600 comprend plusieurs éléments chauffants 109a et plusieurs éléments chauffants 109b. Les éléments chauffants 109a et 109b n'ont pas été représentés en figure 8 afin de ne pas surcharger le dessin. Les éléments chauffants 109a et 109b du commutateur 600 sont aptes à former, dans la région 103 en matériau à changement de phase, plusieurs paires de zones 113a 113b jointives, chaque zone 113a, 113b étant sensiblement centrée sur l'endroit où l'élément chauffant 109a, 109b est en contact mécanique avec la région 103.

Dans l'exemple représenté, les éléments chauffants 109a, 109b, 109c et 109d du commutateur 600 sont aptes à former plusieurs ensembles 601 comprenant chacun des zones 113a et 113b interposées latéralement entre une rangée de zones 113c et une rangée de zones 113d. Plus précisément, dans l'exemple illustré, le commutateur 600 comprend trois ensembles 601-1, 601-2 et 601-3 interposés latéralement entre les électrodes 107c et 107d. Dans l'exemple représenté, les zones 113c de l'ensemble 601-1 et les zones 113d adjacentes de l'ensemble 601-2 s'interpénètrent, et les zones 113c de l'ensemble 601-2 et les zones 113d adjacentes de l'ensemble 601-3 s'interpénètrent.

Dans l'exemple illustré en figure 8, les électrodes 107a des ensembles 601-1, 601-2 et 601-3 sont connectées à une même électrode 607a, et les électrodes 107b des ensembles 601-1, 601-2 et 601-3 sont connectées à une même électrode 607b. Par ailleurs, bien que cela n'ait pas été détaillé en figure 8, les zones 113c des ensembles 601-1, 601-2 et 601-3 sont par exemple connectées à l'électrode 107c, et les zones 113d des ensembles 601-1, 601-2 et 601-3 sont par exemple connectées à l'électrode 107d.

Bien que la figure 8 illustre un exemple dans lequel le commutateur 600 comprend trois ensembles 601 comportant chacun une rangée de zones 113c et une rangée de zones 113d, le commutateur 600 peut, à titre de variante, comprendre un nombre quelconque, supérieur ou égal à un, d'ensembles 601, chaque ensemble 601 pouvant en outre comporter un nombre quelconque, supérieur ou égal à zéro, de rangées de zones 113c et de rangées de zones 113d. Chaque rangée de zones 113c et chaque rangée de zones 113d peut par ailleurs comprendre un nombre quelconque, supérieur ou égal à zéro, de zones 113c et 113d, respectivement. Dit autrement, le commutateur 600 peut comprendre un nombre quelconque, supérieur ou égal à un, d'éléments chauffants 109a et un nombre quelconque, supérieur ou égal à un, d'éléments chauffants 109b, le commutateur 600 pouvant en outre comprendre un nombre quelconque d'éléments chauffants 109c et/ou 109d.

Le commutateur 600 présente un fonctionnement et des avantages analogues ou identiques à ceux du commutateur 500. Le commutateur 600 présente en outre l'avantage, du fait de la mise en parallèle de plusieurs zones 113a et 113b, de diminuer la résistance entre les électrodes 607a et 607b. Cela réduit les pertes d'insertion lorsque le commutateur est dans l'état passant, c'est-à-dire que la transmission à l'état passant est améliorée.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la personne du métier est capable de combiner :
- le mode de réalisation du commutateur 300 avec celui du commutateur 100, par exemple de sorte à obtenir une structure analogue à celle du commutateur 100 mais dans laquelle l'élément chauffant 109a n'est pas commandé de sorte à modifier la phase de la zone 113a ;
- le mode de réalisation du commutateur 400 avec celui du commutateur 200 ou 300, par exemple de sorte à obtenir une structure analogue à celle du commutateur 200 ou 300 mais dans laquelle au moins l'une des zones 113a, 113b, 113c et 113d est disjointe d'au moins l'une des autres zones adjacentes à la zone considérée ;
- le mode de réalisation du commutateur 200 avec celui du commutateur 500 ou 600, par exemple de sorte à obtenir une structure analogue à celle du commutateur 500 ou 600 mais dépourvue de l'électrode 107c et des zones 113c ; et
- le mode de réalisation du commutateur 300 avec celui du commutateur 500 ou 600, par exemple de sorte à obtenir une structure analogue à celle du commutateur 500 ou 600 mais dans laquelle l'élément chauffant 109a n'est pas commandé de sorte à modifier la phase de la ou des zones 113a.

Enfin, la mise en œuvre pratique des modes de réalisation et variantes décrits est à la portée de la personne du métier à partir des indications fonctionnelles données ci-dessus. En particulier, la personne du métier est capable d'intégrer les commutateurs 100, 200, 300, 400, 500 et 600 précédemment décrits dans divers dispositifs radiofréquence tels qu'une ligne à microruban, un guide d'ondes coplanaire (« Coplanar Waveguide » - CPW, en anglais), etc.

Par ailleurs, les modes de réalisation décrits ne se limitent pas aux exemples particuliers de matériaux et de dimensions mentionnés dans la présente description.

## Revendications

1. Commutateur (100 ; 200 ; 300 ; 400 ; 500 ; 600) comprenant :
- des première, deuxième et troisième électrodes (107a, 107b, 107d ; 607a, 607b, 107d) ;
- une région (103) en un matériau à changement de phase reliant les première, deuxième et troisième électrodes ; et
- des premier, deuxième et troisième éléments chauffants (109a, 109b, 109d) connectés entre une première face de la région en matériau à changement de phase et les première, deuxième et troisième électrodes, respectivement ; et
- une couche conductrice (105) continue revêtant intégralement une deuxième face de la région en matériau à changement de phase opposée à la première face,
les deuxième et troisième éléments chauffants (109b, 109d) étant destinés à modifier l'état du matériau à changement de phase dans des première et deuxième zones (113b, 113d) à l'intérieur de ladite région par application respectivement d'un premier signal de commande entre la couche conductrice et le deuxième élément chauffant, et d'un deuxième signal de commande entre la couche conductrice et le troisième élément chauffant,
dans lequel les première et deuxième électrodes (107a, 107b ; 607a, 607b) sont destinées à être connectées à un circuit de communication radiofréquence et la troisième électrode (107d) est destinée à être portée à un potentiel de référence.

2. Commutateur (100 ; 200 ; 400 ; 500 ; 600) selon la revendication 1, dans lequel le premier élément chauffant (109a) est destiné à modifier l'état du matériau à changement de phase dans une troisième zone (113a), différente des première et deuxième zones (113b, 113d), à l'intérieur de la région (103) en matériau à changement de phase.

3. Commutateur (100 ; 400 ; 500 ; 600) selon la revendication 1 ou 2, comprenant en outre une quatrième électrode (107c) et un quatrième élément chauffant (109c) connecté entre la première face de la région (103) en matériau à changement de phase et la quatrième électrode, le quatrième élément chauffant étant destiné à modifier l'état du matériau à changement de phase dans une quatrième zone (113c), différente des première et deuxième zones (113b, 113d), à l'intérieur de ladite région.

4. Commutateur selon la revendication 3, dans lequel les troisième et quatrième éléments chauffants (109d, 109c) sont destinés à être commandés de sorte à faire passer les troisième et quatrième zones (113a, 113c) en matériau à changement de phase d'un premier état à un deuxième état lorsque les premier et deuxième éléments chauffants (109a, 109b) sont commandés de sorte à faire passer les première et deuxième zones (113b, 113d) en matériau à changement de phase du deuxième au premier état.

5. Commutateur (100 ; 200 ; 300 ; 400 ; 500 ; 600) selon l'une quelconque des revendications 1 à 4, dans lequel les première, deuxième et troisième électrodes (107a, 107b, 107d ; 607a, 607b, 107d) sont connectées respectivement à des première, deuxième et troisième régions conductrices (111a, 111b, 111d) correspondant chacune à une électrode de conduction d'un transistor MOS formé dans un substrat (101).

6. Commutateur (100 ; 200 ; 300 ; 400 ; 500 ; 600) selon l'une quelconque des revendications 1 à 5, dans lequel les première, deuxième et troisième électrodes (107a, 107b, 107d ; 607a, 607b, 107d) sont connectées respectivement à des premier, deuxième et troisième circuits de commande (115a, 115b, 115d) comprenant chacun un nœud (121) d'application d'un potentiel de commande.

7. Commutateur (100 ; 200 ; 300 ; 500 ; 600) selon l'une quelconque des revendications 1 à 6, dans lequel les première et deuxième zones (113b, 113d) s'interpénètrent.

8. Commutateur (400) selon l'une quelconque des revendications 1 à 6, dans lequel les première et deuxième zones (113b, 113d) sont disjointes.

9. Commutateur (500 ; 600) selon l'une quelconque des revendications 1 à 8, comprenant en outre au moins un troisième élément chauffant (109d) supplémentaire connecté entre la première face de la région (103) en matériau à changement de phase et la troisième électrode (107d), chaque troisième élément chauffant supplémentaire étant destiné à modifier l'état du matériau à changement de phase dans une deuxième zone (113d) supplémentaire à l'intérieur de ladite région.

10. Commutateur (600) selon l'une quelconque des revendications 1 à 9, comprenant en outre au moins un deuxième élément chauffant (109b) supplémentaire connecté entre la première face de la région (103) en matériau à changement de phase et la deuxième électrode (607b), chaque deuxième élément chauffant supplémentaire étant destiné à modifier l'état du matériau à changement de phase dans une première zone (113b) supplémentaire à l'intérieur de ladite région.

11. Commutateur selon l'une quelconque des revendications 1 à 10, dans lequel la région (103) en matériau à changement de phase est en au moins un matériau chalcogénure, de préférence choisi parmi le GeTe, le GeSbTe, le SbTe et le GeTeN.

## Patentansprüche

1. Schalter (100; 200; 300; 400; 500; 600), aufweisend:
- erste, zweite und dritte Elektroden (107a, 107b, 107d; 607a, 607b, 107d);
- einen Bereich (103) aus einem Phasenwechselmaterial, der die ersten, zweiten und dritten Elektroden koppelt; und
- erste, zweite und dritte Heizelemente (109a, 109b, 109d), die jeweils zwischen einer ersten Oberfläche des Bereichs aus Phasenwechselmaterial und den ersten, zweiten und dritten Elektroden angeschlossen sind; und
- eine durchgehende leitfähige Schicht (105), die eine zweite Oberfläche des Bereichs aus Phasenwechselmaterial gegenüber der ersten Oberfläche integral bedeckt,
wobei das zweite und dritte Heizelement (109b, 109d) dazu vorgesehen sind, den Zustand des Phasenwechselmaterials in ersten und zweiten Zonen (113b, 113d) innerhalb des Bereichs durch jeweiliges Anlegen eines ersten Steuersignals zwischen der leitfähigen Schicht und dem zweiten Heizelement und eines zweiten Steuersignals zwischen der leitfähigen Schicht und dem dritten Heizelement zu modifizieren,
wobei die erste und zweite Elektrode (107a, 107b; 607a, 607b) dazu vorgesehen sind, mit einer Hochfrequenz-Kommunikationsschaltung verbunden zu werden, und die dritte Elektrode (107d) dazu vorgesehen ist, auf ein Referenzpotenzial gebracht zu werden.

2. Schalter (100; 200; 400; 500; 600) gemäß Anspruch 1, wobei das erste Heizelement (109a) dazu vorgesehen ist, den Zustand des Phasenwechselmaterials in einer dritten Zone (113a) zu verändern, die sich von den ersten und zweiten Zonen (113b, 113d) innerhalb des Bereichs (103) des Phasenwechselmaterials unterscheidet.

3. Schalter (100; 400; 500; 600) gemäß Anspruch 1 oder 2, der ferner eine vierte Elektrode (107c) und ein viertes Heizelement (109c) aufweist, das zwischen der ersten Oberfläche des Bereichs (103) des Phasenwechselmaterials und der vierten Elektrode verbunden ist, wobei das vierte Heizelement dazu vorgesehen ist, den Zustand des Phasenwechselmaterials in einer vierten Zone (113c) zu modifizieren, die sich von den ersten und zweiten Zonen (113b, 113d) innerhalb des Bereichs unterscheidet.

4. Schalter gemäß Anspruch 3, wobei die dritten und vierten Heizelemente (109d, 109c) so gesteuert werden sollen, dass die dritten und vierten Zonen (113a, 113c) des Phasenwechselmaterials von einem ersten Zustand in einen zweiten Zustand wechseln, wenn die ersten und zweiten Heizelemente (109a, 109b) so gesteuert werden, dass die ersten und zweiten Zonen (113b, 113d) des Phasenwechselmaterials vom zweiten in den ersten Zustand wechseln.

5. Schalter (100; 200; 300; 400; 500; 600) gemäß einem der Ansprüche 1 bis 4, wobei die ersten, zweiten und dritten Elektroden (107a, 107b, 107d; 607a, 607b, 107d) jeweils mit ersten, zweiten und dritten leitenden Bereichen (111a, 111b, 111d) verbunden sind, die jeweils einer Leitungselektrode eines MOS-Transistors entsprechen, der in einem Substrat (101) ausgebildet ist.

6. Schalter (100; 200; 300; 400; 500; 600) gemäß einem der Ansprüche 1 bis 5, wobei die ersten, zweiten und dritten Elektroden (107a, 107b, 107d; 607a, 607b, 107d) jeweils mit ersten, zweiten und dritten Steuerschaltungen (115a, 115b, 115d) verbunden sind, die jeweils einen Knoten (121) zum Anlegen eines Steuerpotentials aufweisen.

7. Schalter (100; 200; 300; 500; 600) gemäß einem der Ansprüche 1 bis 6, wobei die ersten und zweiten Zonen (113b, 113d) einander durchdringen.

8. Schalter (400) gemäß einem der Ansprüche 1 bis 6, wobei die ersten und zweiten Zonen (113b, 113d) getrennt sind.

9. Schalter (500; 600) gemäß einem der Ansprüche 1 bis 8, der ferner mindestens ein zusätzliches drittes Heizelement (109d) aufweist, das zwischen der ersten Oberfläche des Bereichs (103) aus Phasenwechselmaterial und der dritten Elektrode (107d) verbunden ist, wobei jedes zusätzliche dritte Heizelement dazu vorgesehen ist, den Zustand des Phasenwechselmaterials in einer zusätzlichen zweiten Zone (113d) innerhalb des Bereichs zu modifizieren.

10. Schalter (600) gemäß einem der Ansprüche 1 bis 9, der ferner mindestens ein zusätzliches zweites Heizelement (109b) aufweist, das zwischen der ersten Oberfläche des Bereichs (103) aus Phasenwechselmaterial und der zweiten Elektrode (607b) verbunden ist, wobei jedes zusätzliche zweite Heizelement dazu vorgesehen ist, den Zustand des Phasenwechselmaterials in einer zusätzlichen ersten Zone (113b) innerhalb des Bereichs zu modifizieren.

11. Schalter gemäß einem der Ansprüche 1 bis 10, wobei der Bereich des Phasenwechselmaterials (103) aus mindestens einem Chalcogenidmaterial besteht, das vorzugsweise aus GeTe, GeSbTe, SbTe und GeTeN ausgewählt ist.

## Claims

1. Switch (100; 200; 300; 400; 500; 600) comprising:
- first, second and third electrodes (107a, 107b, 107d; 607a, 607b, 107d);
- a region (103) made of a phase-change material coupling the first, second, and third electrodes; and
- first, second, and third heater elements (109a, 109b, 109d) connected between a first surface of the region of phase-change material and the first, second, and third electrodes, respectively; and
- a continuous conductive layer (105) integrally coating a second surface of the region of phase-change material opposite to the first surface,
the second and third heater elements (109b, 109d) being intended to modify the state of the phase-change material in first and second areas (113b, 113d) within said region by application respectively of a first control signal between the conductive layer and the second heater element, and of a second control signal between the conductive layer and the third heater element,
wherein the first and second electrodes (107a, 107b; 607a, 607b) are intended to be connected to a radio frequency communication circuit and the third electrode (107d) is intended to be taken to a reference potential.

2. Switch (100; 200; 400; 500; 600) according to claim 1, wherein the first heater element (109a) is intended to modify the state of the phase-change material in a third area (113a), different from the first and second areas (113b, 113d), within the region (103) of phase-change material.

3. Switch (100; 400; 500; 600) according to claim 1 or 2, further comprising a fourth electrode (107c) and a fourth heater element (109c) connected between the first surface of the region (103) of phase-change material and the fourth electrode, the fourth heater element being intended to modify the state of the phase-change material in a fourth area (113c), different from the first and second areas (113b, 113d), within said region.

4. Switch according to claim 3, wherein the third and fourth heater elements (109d, 109c) are intended to be controlled so as to have the third and fourth zones (113a, 113c) of phase-change material change from a first state to a second state when the first and second heater elements (109a, 109b) are controlled so as to have the first and second areas (113b, 113d) of phase-change material change from the second to the first state.

5. Switch (100; 200; 300; 400; 500; 600) according to any of claims 1 to 4, wherein the first, second, and third electrodes (107a, 107b, 107d; 607a, 607b, 107d) are respectively connected to first, second, and third conductive regions (111a, 111b, 111d), each corresponding to a conduction electrode of a MOS transistor formed in a substrate (101).

6. Switch (100; 200; 300; 400; 500; 600) according to any of claims 1 to 5, wherein the first, second, and third electrodes (107a, 107b, 107d; 607a, 607b, 107d) are respectively connected to first, second, and third control circuits (115a, 115b, 115d), each comprising a node (121) of application of a control potential.

7. Switch (100; 200; 300; 500; 600) according to any of claims 1 to 6, wherein the first and second areas (113b, 113d) interpenetrate.

8. Switch (400) according to any of claims 1 to 6, wherein the first and second areas (113b, 113d) are separate.

9. Switch (500; 600) according to any of claims 1 to 8, further comprising at least one additional third heater element (109d) connected between the first surface of the region (103) of phase-change material and the third electrode (107d), each additional third heater element being intended to modify the state of the phase-change material in an additional second area (113d) within said region.

10. Switch (600) according to any of claims 1 to 9, further comprising at least one additional second heater element (109b) connected between the first surface of the region (103) of phase-change material and the second electrode (607b), each additional second heater element being intended to modify the state of the phase-change material in an additional first area (113b) within said region.

11. Switch according to any of claims 1 to 10, wherein the region of phase-change material (103) is made of at least one chalcogenide material, preferably selected from among GeTe, GeSbTe, SbTe, and GeTeN.
